# EUROPEAN PATENT APPLICATION

(11) **EP 3 575 804 A1**
(43) Date of publication of application: **04.12.2019**
(21) Application number: 18175216.3
(22) Date of filing: 30.05.2018
(51) Int. Cl.: G01R 15/06, G01R 15/04

(54) **VOLTAGE SENSOR**

(71) Applicant: 3M Innovative Properties Company, Saint Paul, MN 55133-3427 (US)
(72) Inventor: Gravermann, Mark, 41812 Erkelenz (DE); Weichold, Jens, 41812 Erkelenz (DE); Stollwerck, Gunther, 47802 Krefeld (DE)
(74) Representative: Müller, Bruno

(57) **Abstract**

The invention relates to a separable connector (1) for a medium or high voltage power network for receiving an electrical conductor (6) capable of conducting a medium or high voltage, the separable connector comprising:
- an insulation body (12) surrounding the electrical conductor (6), wherein the insulation body (12) comprises at least two openings,
- optionally an inner semi conductive or electrically conductive layer (3) on the inside of the insulation body (12),
- a semi conductive or electrically conductive layer (13) on the outside of the insulation body (12),
- an electrically insulating intermediate layer (15),
- an electrically conductive outer screen (16),
wherein the electrically conductive outer screen (16) extends over the entire semi conductive or electrically conductive layer (13) and wherein the electrically insulating intermediate layer (15) extends between the semi conductive or electrically conductive layer (13) and the electrically conductive outer screen (16).

## Description

The invention relates to a separable connector for a medium or high voltage power network for receiving an electrical conductor capable of conducting a medium or high voltage. The invention also relates to the use of a separable connector as a voltage sensor for a medium or high voltage power network. And the invention relates to a medium or high voltage grid with a separable connector according to the invention.

Voltage sensors are used in medium or high voltage power grids to determine the actual state of the power grid and to calculate the power flow in the grid to keep the grid frequency and the voltage amplitude in the desired ranges. Voltage sensors may be used with different levels of accuracy in the power grid. For some applications a high accuracy of measurement is necessary and for other applications a lower accuracy of measurement is sufficient. In some instances, a voltage indication may be sufficient.

Voltage sensors for medium or high voltage power grid applications are known in the art. A common way to measure a voltage are voltage dividers. Voltage dividers for sensing a voltage of an inner conductor of a medium or high voltage power network are known, e. g., from the German patent application DE 37 02 735 A1. Voltage dividers can be formed by a plurality of resistors, capacitors or inductances. Resistors, capacitors and inductances are referred to as impedances in this disclosure.

Generally, one end of a voltage divider is electrically connected to the power conductor or otherwise kept on the high or medium voltage to be measured, while the opposed end is held on lower voltage or on earth potential. Voltage dividers formed by a greater number of dividing elements which are connected in series are advantageous because the voltage drop across each of the dividing elements is smaller than with only two dividing elements, thus reducing electrical stress and the risk of failure.

An example of a voltage divider in a high voltage application is shown in the European patent application EP 2 605 023 A1, where the voltage divider comprises a plurality of resistive elements in an angled configuration. The group of elements is arranged on an insulating support the shape of which is such that the creepage distance of the support is equal to or longer than the sum of the creepage distances of the individual resistances. According to EP 2 605 023 A1, the divider can be embedded in insulating material, which is preferably a resin.

Other voltage sensor systems are known, such as disclosed in the patent application US 7,199,571 B2, which describes a sensor solution for use in a separable connector that includes an insulating body and first and second electrical conductors in contact with the insulating body. The first and second electrical conductors have adjacent surfaces configured such that when an electrical field potential is applied between the conductors, an electrical field is formed by the conductors. The insulating body has an opening positioned between the conductors and adapted to receive a sensor such that the portion of the sensor is subjected to the electrical field.

The European patent application EP 1 391 740 A2 discloses a system for sensing current and voltage. It comprises a toroidal inductive pickup for measuring the current and a resistive pickup for measuring the voltage, a shielded connector or terminal in which the voltage pickup is integrated, and an insulation bushing or fixed base of the equipment to be connected. The system is complemented by a corresponding electronic circuit for signal pickup and processing.

And finally, European patent application EP 2 696 206 A1 discloses a medium or high voltage arrangement with cable connection terminal and voltage sensor, wherein the voltage sensor has a resistive voltage divider and shielding electrodes. In order to enhance the accuracy of voltage measurement at medium or high voltage pole parts, the voltage sensor is applied as a voltage sensor module, which is integrated in a further cable connection terminal, and shielding electrodes are integral part of the voltage sensor module or integral part of an insulating housing part of the terminal.

In view of the above cited prior art there is still a need for a simple and cost effective solution for measuring and/or indicating a voltage in a medium or high voltage power grid.

In many switch gears in the electrical power grid separable connectors are used which are fully screened, e. g. they comprise a semi conductive or electrically conductive outer layer. The invention relates to a separable connector that is modified such that it can be used as a sensor or indicator for measuring a voltage of a medium or high voltage power network. The invention also relates to the use of the separable connector according to the invention for measuring or indicating a voltage of a medium or high voltage power network. And finally, the invention relates to a medium or high voltage power grid with a separable connector according to the invention.

The present invention provides a separable connector for a medium or high voltage power network for receiving an electrical conductor capable of conducting a medium or high voltage, the separable connector comprising:
- an insulation body surrounding the electrical conductor, wherein the insulation body comprises at least two openings,
- optionally an inner semi conductive or conductive layer on the inside of the insulation body,
- a semi conductive or electrically conductive layer on the outside of the insulation body,
- an electrically insulating intermediate layer,
- an electrically conductive outer screen,
wherein the electrically conductive outer screen extends over the entire semi conductive or electrically conductive layer and wherein the electrically insulating intermediate layer extends between the semi conductive or electrically conductive layer and the electrically conductive outer screen.

According to the invention, a separable connector for receiving an electrical conductor capable of conducting a medium or high voltage is modified such that it can be used as a sensor for measuring or indicating a voltage in a medium or high voltage power network. In switchgears separable connectors are usually used to connect cables of the power network to bushings of the switchgear. The separable connector according to the invention is designed such to be capable of receiving an inner electrical conductor capable of conducting a medium or high voltage of a medium or high voltage power network. The electrical conductor can be any kind of conductor that is capable of conducting a medium or high voltage. Usually such conductors comprise aluminum or copper or a combination thereof.

The separable connector further comprises an insulation body surrounding the electrical conductor, wherein the insulation body comprises at least two openings. The insulation body may be arranged directly on the inner electrical conductor, not taking into account any thin (semi-) conductive layer on the inner conductor that shall prevent air voids between inner conductor and main insulation - such a layer is considered to be part of the inner conductor. The insulation body may comprise any of the known and standardized shape such as for example the shape of a T-body or an elbow. If it comprises the shape of a T-body, it provides at least three openings. One opening may be adapted to receive the inner electrical conductor. A second opening may be adapted to receive a bushing from, for example, a switch gear. And a third opening may be adapted for receiving a rear insert.

If it comprises the shape of an elbow, it provides at least two openings. One opening may be adapted to receive the inner electrical conductor. A second opening may be adapted to receive for example a bushing.

Most cable accessories, such as also separable connectors, have further layers, arranged around the insulating layer, e. g. a semi conductive layer or an electrically conductive layer. The separable connector according to the invention also comprises such a conductive layer (either semi conductive or electrically conductive) on the outside of the insulation body. The separable connector according to the invention may, depending on its design and the properties of the cable termination, also provide an inner semi conductive or electrically conductive layer, e. g. a medium or high voltage electrode. The purpose of such a layer is usually to provide a safe environment for the cable end carrying medium or high voltage.

The separable connector according to the invention is modified compared to existing separable connectors by at least two additional components, one being an electrically insulating intermediate layer and the other being an electrically conductive outer screen, wherein the electrically conductive outer screen extends over the entire semi conductive or electrically conductive layer and wherein the electrically insulating intermediate layer extends between the semi conductive or electrically conductive layer and the electrically conductive outer screen. These two additional layers may be easily produced and mounted to a separable connector. The separable connector according to the invention therefore provides a cost effective solution for a tool for measuring and/or indicating a voltage. It is even possible to retrofit existing separable connectors with the two additional layers in order to convert the separable connector into a measurement device or an indicator. The only steps that have to be conducted for this conversion are: to disconnect the ground contact of the existing separable connector; to enclose the separable connector with the two additional layers (electrically insulating intermediate layer and electrically conductive outer screen); and connect the additional electrical components that will be described further down with ground.

The electrically insulating intermediate layer may be made out of any suitable electrically insulating material, such as for example epoxy resin, silicone rubber or any other known insulation material. It may be provided in the form of a film, a coating or a paint etc.

The electrically conductive screen can be made out of any electrically conductive material, such as for example aluminium, copper, etc. Further embodiments of the electrically conductive screen will be described below.

According to one embodiment of the invention, the separable connector may comprise at least one high voltage impedance and at least one low voltage impedance for building a voltage divider for sensing a voltage of the inner electrical conductor. As already said above, voltage dividers are a commonly known and used way for measuring a voltage in a medium or high voltage power network. Generally, one end of a voltage divider is electrically connected to the power conductor or otherwise kept on the high voltage to be measured, while the opposed end is held on lower voltage or on earth potential. Voltage dividers may be formed by a greater number of dividing elements which may be connected in series or in other suitable and known configurations. This may be advantageous because the voltage drop across each of the dividing elements is smaller than with only two dividing elements, thus reducing electrical stress and the risk of failure. Voltage dividers can be formed by a plurality of resistors, capacitors or inductances. Resistors, capacitors and inductances are referred to as impedances in this disclosure.

Usually old switchgears do not provide any measurement devices for voltage measurements. Since the switchgears are nods in a power network it is helpful to measure voltage and current at these points, if a power flow in the power network needs to be determined. With the power flow it is possible to control the grid frequency and the voltage amplitude, which helps to make sure that power of high quality can be supplied to end users. Therefore providing a separable connector that can easily be used as a sensor for measuring or indicating a medium or high voltage is a big advantage. Especially since it is possible to retrofit or update existing already installed separable connectors, the invention provides a big advantage.

According to a further embodiment of the invention, the high voltage impedance is built by a capacitive voltage divider with the capacity build by the semi conductive or electrically conductive outer layer of the insulation body and the inner electrical conductor. It is also possible to build the capacity by the semi conductive or electrically conductive outer layer of the insulation body and the inner semi conductive or electrically conductive layer of the insulation body. This embodiment is especially advantageous because existing structures, e. g. a semi conductive or electrically conductive outer and/or inner layer and an inner electrical conductor, of the separable connector can be used to build a capacity of a voltage divider. Parts of a sensor comprising a voltage divider can therefore be built by using existing structures of a separable connector.

According to a further embodiment of the invention the low voltage impedance may also comprise at least one low voltage capacitor. It is possible that the low voltage impedance comprises other intelligent features such as for example an energy harvesting element or a partial discharge protection element.

The low voltage impedance may comprise at least one capacitor mounted on a printed circuit board. Such electronic components and/or parts of electronic circuits are standard components that are readily available at moderate costs. Also, their electrical properties are generally precisely specified. The low voltage impedance may comprise one, two, three or more capacitors mounted on the printed circuit board. The printed circuit board with the at least one low voltage impedance may be arranged inside of the electrically conductive outer screen of the separable connector. Such an arrangement provides the advantage that the outer screen protects the low voltage impedance element against environmental impacts. It is also possible to integrate the electronic components related to the low voltage impedance element in a signal cable that may be used to transmit data from the sensor and/or indicator to a system.

The high voltage impedance and the low voltage impedance may be electrically connected in series such as to be operable as a voltage divider for sensing a voltage of the inner electrical conductor of the separable connector. The voltage divider may be electrically connected between the inner electrical conductor (carrying medium or high voltage) and low voltage or electrical ground (earth potential).

According to another embodiment, the electrically insulating intermediate layer may be a coating or a film. It may also comprise separate spacer elements and not extend over the entire outer screen. The main purpose of the electrically insulating intermediate layer is to avoid a direct mechanical and electrical contact between the outer screen and the outer semi conductive or electrically conductive layer of the insulation body. The intermediate layer may be made out of any suitable electrically insulating material, such as, for example, epoxy resin, silicone rubber, nylon, polyethylene etc. The electrically insulating layer may extend over the entire semi conductive or electrically conductive layer, which is arranged on the outside of the insulation body. It may also extend over the printed circuit board carrying the low voltage impedance. Providing the intermediate layer in form of a coating or film provides the advantage that it is easy to install and that it is possible to retrofit existing already installed separable connectors. The intermediate layer may easily be applied to the separable connector. It is also possible to apply it to the inside of the electrically conductive outer screen, as will be described in more detail below.

According to another embodiment, the electrically conductive outer screen may be a cover, a coating or a film comprising electrically conductive material such as, for example, aluminium, copper, steel or a combination thereof. The electrically conductive outer screen extends over the entire semi conductive or electrically conductive layer wherein the electrically insulating intermediate layer extends between the semi conductive or electrically conductive outer layer and the electrically conductive outer screen. Providing the electrically conductive outer screen in the form of a cover, coating or film provides the advantage that it is easy to install and that it is possible to retrofit existing already installed separable connectors.

When the electrically conductive outer screen is provided as a cover, it may comprise at least two parts that can be interlocked with each other. The two parts may be designed such that they can be installed over an existing already installed separable connector. Interlocking the two parts may be done with any kind of existing mechanical locking means. The shape of the cover may be adapted to the size and the shape of the insulation body of the separable connector. Since separable connectors are usually used in switchgears, where the space is limited, a size and a design that is space saving is advantageous for the cover.

The invention also relates to the use of a separable connector as described above as a voltage sensor or indicator for a medium or high voltage power network. According to the invention a separable connector with some simple modifications can be used to sense or indicate a voltage in a power network. The advantage of the invention is that it provides a simple solution for a voltage sensor and that it is possible to retrofit or update existing and even already installed separable connectors as sensors.

Finally, the invention relates to a medium or high voltage power network with a separable connector as described above for sensing a voltage in the medium or high voltage power network.

The invention will now be described in more detail with reference to the following Figures exemplifying particular embodiments of the invention:
- Fig. 1: is a schematical drawing of a separable connector for a medium or high voltage power network according to the invention;
- Fig. 2: is an enlarged drawing of section A in Fig. 1 and
- Fig. 3: is an electrical circuit diagram of the voltage divider of the separable connector for a medium or high voltage network according to the invention.

Herein below various embodiments of the present invention are described and shown in the drawings wherein like elements are provided with the same reference numbers.

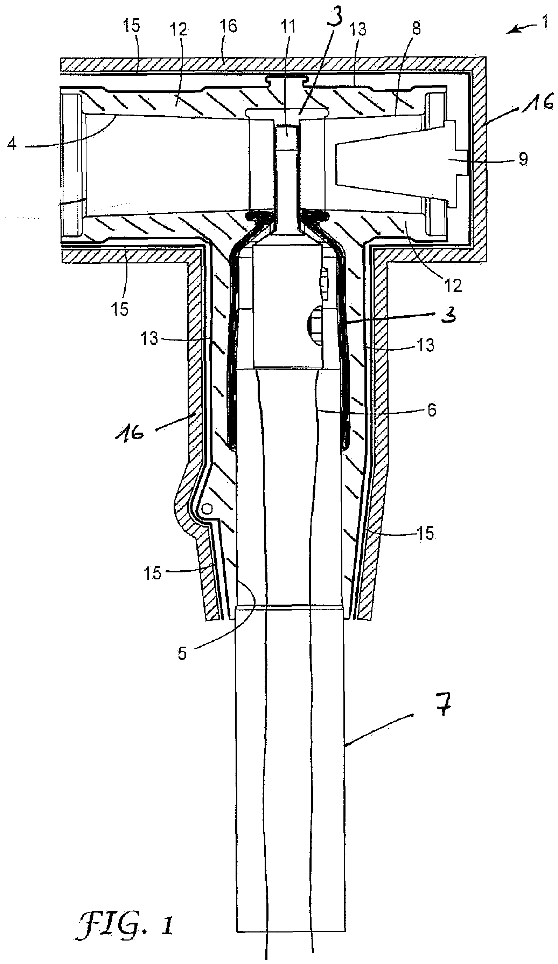

Fig. 1 is a schematical drawing of a separable connector 1 according to the invention. The separable connector 1 of Fig. 1 is a T-body with three openings, a first opening 5 for receiving an inner electrical conductor 6 that is electrically connected to a cable 7 of a power network (not shown), a second opening 4 for receiving a bushing (not shown) of a switchgear 2 and a third opening 8 for receiving a plug such as for example a rear insert 9 (only schematically shown in the drawing).

Usually separable connectors 1 are installed in switchgears and provide an opening 4 for receiving a bushing of the switchgear. The bushing gets electrically connected, e. g. over a high voltage electrode 11 with the inner electrical conductor 6 that is electrically connected to a cable 7 of a power network. The separable connector 1 thus is used to connect the switchgear electrically to the power network. As already laid out above, the separable connector 1 provides a further opening 8, which may be used to insert any kind of plug with or without any functionality. In Fig. 1 the opening 8 receives a rear insert 9 without any technical functionality (only shown schematically in the drawing).

The inner electrical conductor 6 and the high voltage electrode 11 of the separable connector 1 are embedded in an insulation body 12. The insulation body 12 therefore surrounds the inner electrical conductor 6 at least partially. The insulation body 12 has a shape of a T-body and provides the above described three openings 4, 5 and 9. The insulation body 12 may at least partially be in direct contact with the inner electrical conductor 6 or the cable 7. On its inside the insulation body provides an optional inner semi conductive or electrically conductive layer 3, the medium or high voltage electrode. The electrode has the purpose of securing the medium or high voltage carrying end of the cable 7. The inner semi conductive or electrically conductive layer extends partially on the inside of the insulation body 12, especially in those areas, where the cable conductor 6 is provided without any isolation. On its outside the insulation body 12 provides a semi conductive or electrically conductive layer 13. The semi conductive or electrically conductive layer 13 extends over the entire outer surface of the insulation body 12.

On the side of the third opening 8, which contains the rear insert 9, an additional cap or closure may provided that is put over the opening 8 in order to close the opening 8 and cover the rear insert 9. The cover may be made out of electrically conductive material.

The separable connector 1 further provides an electrically insulating intermediate layer 15. The intermediate layer 15 comprises any of the above mentioned suitable materials that are electrically insulating. The intermediate layer 15 may be a separate layer or it may be an additional layer on the insulation body 12 covering the outer semi conductive or electrically conductive layer 13.

The separable connector 1 further provides an electrically conductive outer screen 16. The size and the shape of the outer screen 16 are adapted to the size and the shape of the insulation body 12 of the separable connector 1. The electrically conductive outer screen 16 may be, for example, a metal cover that comprises two parts (shells) that may be interlocked with each other (not shown in the drawings). According to one embodiment, the electrically conductive outer screen 16 provides an electrically insulating coating on its inside, wherein this coating may build the electrically insulating intermediate layer 15 of the separable connector 1 according to the invention. Such an embodiment is especially advantageous, because it allows for very simple updating and retrofitting of existing and also for already installed separable connectors.

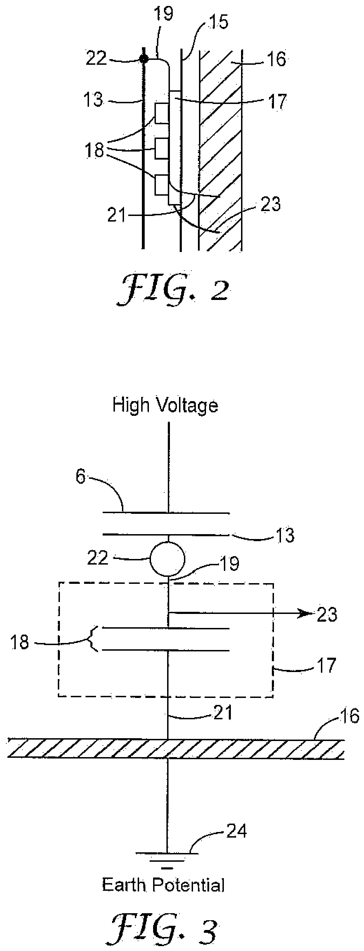

In order to function as a voltage sensor or indicator for sensing medium or high voltage of the inner electrical conductor 6, the separable connector 1 according to the invention comprises at least one high voltage impedance and at least one low voltage impedance for building a voltage divider for sensing a voltage of the inner electrical conductor 6. The high voltage impedance is built by a capacitive voltage divider with a capacity build by the semi conductive or electrically conductive outer layer 13 and the inner electrical conductor 6 or the inner semi conductive or electrically conductive layer 3. The connection to high voltage is realized through the cable 6 itself or the connection between the inner semi conductive or electrically conductive layer 3 and the cable 6. The low voltage impedance of the embodiment shown in Fig. 1 is built by at least one capacitor mounted on a printed circuit board 17 (see Fig. 2). The printed circuit board 17 comprises several capacitors 18 that are electrically connected in series. On its one end it is electrically connected via the connection 19 to the semi conductive or electrically conductive layer 13 functioning as one electrode of the capacitive high voltage divider. On its other end it is electrically connected via the connection 21 with the electrically conductive outer screen, which is on ground potential. With such a configuration, a voltage divider can be established with very easy means. It is even possible to retrofit or update existing separable connectors 1 in order provide them with sensing functionalities.

Fig. 3 is an electrical circuit diagram of the voltage divider of the separable connector for a medium or high voltage network according to the invention. From the top the electrical circuit diagram shows the following:
- high voltage end resembling to the voltage of the power network;
- first high voltage electrode realized in the separable connector by the inner electrical conductor 6 of the separable connector 1 or the inner semi conductive or electrically conductive layer 3;
- second high voltage electrode realized by the semi or electrically conductive layer 13 of the separable connector 1;
- first and second high voltage electrode building the high voltage capacitor of the voltage divider;
- connection point of the high voltage impedance and the low voltage impedance, realized by connection 22 to the outer semi conductive or electrically conductive layer 13;
- printed circuit board 17 carrying at least one low voltage impedance (capacitor) 18 and a device for delivering a signal output 23;
- low voltage end realized by a connection 21 to the electrically conductive outer screen (metal cover) 16;
- connection to ground 24.

## Claims

1. Separable connector (1) for a medium or high voltage power network for receiving an electrical conductor (6) capable of conducting a medium or high voltage, the separable connector comprising:
- an insulation body (12) surrounding the electrical conductor, wherein the insulation body comprises at least two openings,
- optionally an inner semi conductive or electrically conductive layer on the inside of the insulation body,
- an outer semi conductive or electrically conductive layer (13) on the outside of the insulation body,
- an electrically insulating intermediate layer (15),
- an electrically conductive outer screen (16),
wherein the electrically conductive outer screen extends over the entire semi conductive or electrically conductive layer and wherein the electrically insulating intermediate layer extends between the semi conductive or electrically conductive layer and the electrically conductive outer screen.

2. Separable connector according to claim 1, wherein the separable connector (1) comprises at least one high voltage impedance (6, 13) and at least one low voltage impedance (18) for building a voltage divider for sensing a voltage of the inner electrical conductor.

3. Separable connector according to claim 1 or 2, wherein the high voltage impedance is built by a capacitive voltage divider with the capacity built by the outer semi conductive or electrically conductive layer (13) and the inner electrical conductor (6) or the optional inner semi conductive or electrically conductive layer.

4. Separable connector according to any of the preceding claims, wherein the low voltage impedance comprises at least one low voltage capacitor (18).

5. Separable connector according to claim 4, wherein the low voltage impedance comprises at least one low voltage capacitor (18) mounted on a printed circuit board (17).

6. Separable connector according to claim 5, wherein the printed circuit board (17) is arranged inside of the electrically conductive outer screen (16).

7. Separable connector according to any of the claims 2 to 6, wherein the at least one high voltage impedance (6, 13) and the at least one low voltage impedance (18) are connected in series such as to build a voltage divider for sensing a voltage of the inner electrical conductor.

8. Separable connector according to any of the claims 2 to 7, wherein the high voltage impedance (18) is directly or indirectly connected to medium or high voltage.

9. Separable connector according to any of the claims 2 to 8, wherein the low voltage impedance is connected to earth potential.

10. Separable connector according to any of the preceding claims, wherein the electrically insulating intermediate layer (15) is a coating, a film, a paint or comprises separate spacer elements out of electrically insulating material.

11. Separable connector according to any of the preceding claims, wherein the electrically conductive outer screen is a cover (16), a coating, a film out of electrically conductive material.

12. Separable connector according to claim 9, wherein the cover (16) comprises at least two parts that can be interlocked with each other.

13. Separable connector according to any of the preceding claims, wherein the electrically conductive outer screen (16) is an electrically conductive cover with an inner insulation coating (15), wherein the inner insulation coating provides the electrically insulating intermediate layer.

14. Use of the separable connector as claimed in any of the claims 1 to 13 as a voltage sensor or indicator for a medium or high voltage power network.

15. A medium or high voltage power network with a separable connector according to any of the claims 1 to 13 for sensing or indicating a voltage in the medium or high voltage power network.
